# EUROPEAN PATENT APPLICATION

(11) **EP 4 667 443 A1**
(43) Date of publication of application: **24.12.2025**
(21) Application number: 24756617.7
(22) Date of filing: 26.01.2024
(51) Int. Cl.: C04B 37/02, B32B 15/04, H01L 23/13, H01L 23/14, H05K 1/03, H05K 3/38

(54) **BONDED BODY AND CERAMIC CIRCUIT BOARD USING SAME**

(30) Priority: 17.02.2023 JP 2023023559
(71) Applicant: Kabushiki Kaisha Toshiba, Tokyo 105-0023 (JP); Toshiba Materials Co., Ltd., Isogo-Ku Yokohama-Shi Kanagawa 235-0032 (JP)
(72) Inventor: FUJISAWA, Sachiko, Yokohama-shi, Kanagawa 235-0032 (JP); SUENAGA, Seiichi, Yokohama-shi, Kanagawa 235-0032 (JP); MORI, Yoichiro, Yokohama-shi, Kanagawa 235-0032 (JP)
(74) Representative: Henkel & Partner mbB
(86) International application number: PCT/JP2024/002404
(87) International publication number: WO 2024/171766

(57) **Abstract**

Provided is a bonded body comprising a titanium nitride layer that contains a predetermined amount of oxygen. A bonded body according to an embodiment of the present invention comprises a nitride-based ceramic member and a metal member bonded to the nitride-based ceramic member via a bonding layer. A titanium nitride layer comprising titanium nitride as a main component is formed in the interface between the nitride-based ceramic member and the bonding layer. The titanium nitride layer comprises a part containing oxygen in an amount of 1 at % or more.

## Description

### [Technical Field]

Embodiments described below relate generally to a bonded body and a ceramic circuit board using a bonded body.

### [Background Art]

In recent years, ceramic circuit boards that have good heat dissipation and thermal cycle test (TCT) characteristics are being developed. For example, Japanese Patent No. 6789955 (Patent Literature 1) discusses a ceramic circuit board in which a ceramic substrate and a copper plate are bonded via a bonding layer. Patent Literature 1 discusses a silicon nitride substrate, an aluminum nitride substrate, an aluminum oxide substrate, etc. Silicon nitride substrates and aluminum nitride substrates are called nitride ceramic substrates. Silicon nitride substrates have high strength, and have a three-point bending strength of not less than 500 MPa. Also, aluminum nitride substrates have high thermal conductivity, and have a thermal conductivity of not less than 160 W/m·K. Nitride ceramic substrates have superior performance compared to oxide ceramic substrates.

In Patent Literature 1, an active metal brazing material is used to bond a nitride ceramic substrate and a copper plate. An active metal brazing material is a brazing material including titanium, which is an active metal. The active metal brazing material is coated between the nitride ceramic substrate and the copper plate; and a bonded body is obtained by thermal bonding. The thermal bonding causes the active metal brazing material layer to become the bonding layer. The active metal brazing material that includes titanium reacts with the nitride ceramic substrate to form a titanium nitride layer. The bonding strength can be increased by a titanium nitride layer forming at the nitride ceramic substrate surface as a portion of the bonding layer.

### [Prior Art Documents]

### [Patent Literature]

Patent Literature 1: Japanese Patent No. 6789955
Patent Literature 2: Japanese Patent No. 4077888
Patent Literature 3: JP-A 2013-211546 (Kokai)
Patent Literature 4: International Publication No. 2021/015122
Patent Literature 5: International Publication No. 2022/244769

### [Summary of Invention]

### [Problem to be Solved by the Invention]

In Patent Literature 1, the bonding layer includes a jutting part jutting from a copper plate end portion. TCT characteristics are improved by controlling the size and hardness of the jutting part. However, no further performance improvement was observed. By investigating the cause, it was found that the oxygen amount inside the titanium nitride layer is a cause. The titanium nitride layer is a hard material. For example, in Japanese Patent No. 4077888 (Patent Literature 2), the Vickers hardness HV of the titanium nitride layer is high, and is not less than 1100. In Patent Literature 2, the TCT characteristics are improved by making the titanium nitride layer harder by including Cu and/or Al in the titanium nitride layer. Cu is a component included in the brazing material; and Al is a component included in the aluminum nitride substrate. These components have been difficult to disperse uniformly. Fluctuation of the dispersion state inside the titanium nitride layer caused partial fluctuation of the properties of the titanium nitride layer.

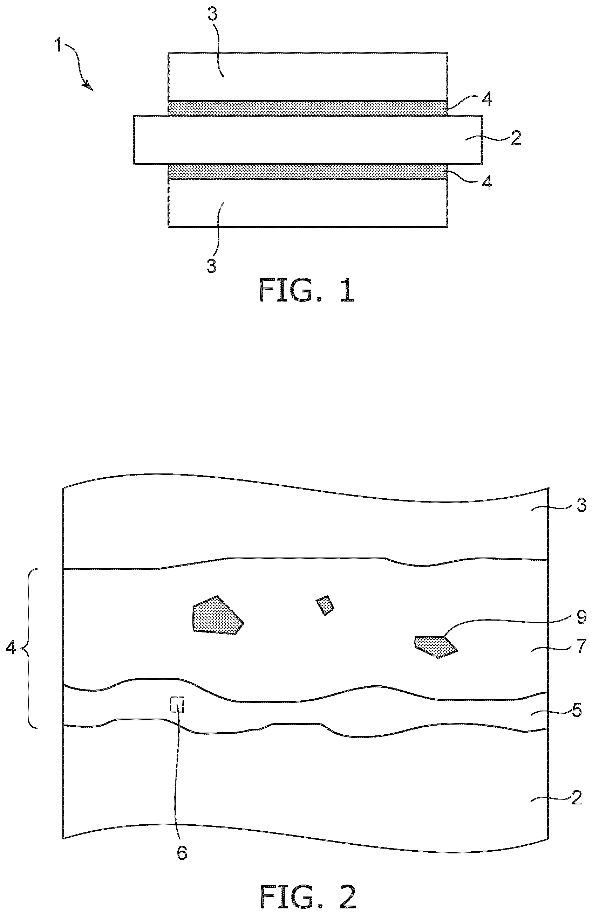

Conventionally, the oxygen content in the titanium nitride layer has been extremely low. For example, FIG. 2 of JP-A 2013-211546 (Kokai) (Patent Literature 3) shows the results of line analysis of a ceramic circuit board in the cross-sectional direction performed using EPMA (electron probe microanalyzer). The relative intensity (%) of the oxygen amount in the titanium nitride layer was small. It is noted that in the results described in Patent Literature 3, the effects of the background are large, and an accurate numerical value of the oxygen amount cannot be ascertained. Also, in Table 1 of International Publication No. 2021/015122 (Patent Literature 4), the oxygen amount in the titanium nitride layer (an interface layer 121 and a nanoparticle layer 131) was 0 at%.

The invention is directed to improve such problems, and to provide a bonded body that includes a prescribed amount of oxygen in the titanium nitride layer.

### [Means for Solving the Problem]

A bonded body according to an embodiment includes a nitride ceramic member, and a metal member bonded with the nitride ceramic member via a bonding layer. A titanium nitride layer that includes titanium nitride as a major component is formed at a nitride ceramic member and the interface between the bonding layer. The titanium nitride layer includes a location at which an oxygen amount is not less than 1 at%.

### [Brief Description of Drawings]

[FIG. 1]
   FIG. 1 is a drawing showing an example of a bonded body according to an embodiment.
[FIG. 2]
   FIG. 2 is a drawing showing an example of a measurement region of a titanium nitride layer.
[FIG. 3]

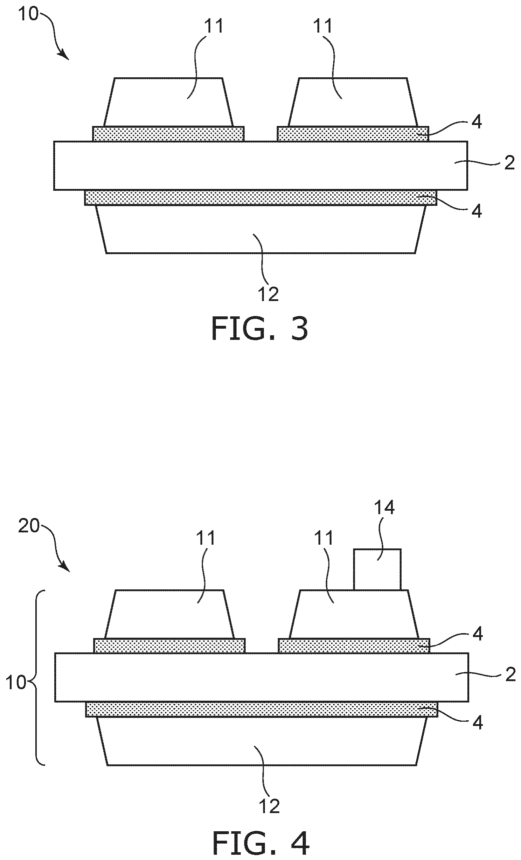

   FIG. 3 is a drawing showing an example of a ceramic circuit board according to an embodiment.
[FIG. 4]
   FIG. 4 is a side view showing an example of a semiconductor device according to an embodiment.

### [Detailed Description]

A bonded body according to an embodiment includes a nitride ceramic member, and a metal member bonded with the nitride ceramic member via a bonding layer. A titanium nitride layer that includes titanium nitride as a major component is formed at an interface between the nitride ceramic member and the bonding layer. The titanium nitride layer includes a location at which an oxygen amount is not less than 1 at%.

FIG. 1 is a side view showing an example of the bonded body according to the embodiment. FIG. 2 is a cross-sectional view showing an example of a measurement region of a titanium nitride layer. In FIGS. 1 and 2, the reference numeral 1 is a bonded body, the reference numeral 2 is a nitride ceramic member, the reference numeral 3 is a metal member, the reference numeral 4 is a bonding layer, the reference numeral 5 is a titanium nitride layer, the reference numeral 6 is a measurement region, the reference numeral 7 is a brazing material layer, and the reference numeral 9 is a Ti-rich region.

The metal member 3 is bonded to the nitride ceramic member 2 via the bonding layer 4. FIG. 1 shows an example in which the metal members 3 are bonded respectively to two surfaces of the nitride ceramic member 2. The metal member 3 may be bonded to only one surface of the nitride ceramic member 2. The number of the metal members 3 bonded to one surface of the nitride ceramic member 2 is not limited to one and may be two or more.

Nitride ceramic members are ceramic sintered bodies including nitrogen as a constituent element. Examples of nitride ceramic members include silicon nitride sintered bodies (including sialon sintered bodies) and aluminum nitride sintered bodies. A sintering aid may be added as necessary. Examples of the sintering aid include at least one compound selected from rare-earth elements, magnesium, titanium, and hafnium. Oxides, nitrides, oxynitrides, silicides, etc., are compounds added as sintering aids. Examples of rare-earth elements include yttrium and lanthanoid elements.

The nitride ceramic member 2 has a substrate shape when used in a ceramic circuit board described below. A nitride ceramic member that has a substrate shape is called a nitride ceramic substrate. It is favorable for the thickness of the nitride ceramic substrate to be within the range of not less than 0.1 mm and not more than 3 mm. When the thickness is less than 0.1 mm, there is a possibility that the strength of the nitride ceramic substrate may be insufficient. When the thickness is greater than 3 mm, there is a possibility that the heat dissipation of the nitride ceramic substrate may be unfavorably affected.

A substrate that is made of a silicon nitride sintered body is called a silicon nitride substrate. It is favorable for the three-point bending strength of the silicon nitride substrate to be not less than 500 MPa, and more favorably not less than 600 MPa. By increasing the strength, the necessary durability can be obtained even when the thickness of the substrate is thin and is not less than 0.1 mm and not more than 4 mm. Also, it is favorable for the thermal conductivity of the silicon nitride substrate to be not less than 50 W/m·K, and more favorably not less than 80 W/m·K. The heat dissipation can be improved by increasing the thermal conductivity. It is favorable for the fracture toughness value of the silicon nitride substrate to be not less than 5.5 MPa·m^{1/2}.

A substrate that is made of an aluminum nitride sintered body is called an aluminum nitride substrate. It is favorable for the thermal conductivity of the aluminum nitride substrate to be not less than 160 W/m·K. It is favorable for the three-point bending strength of the aluminum nitride substrate to be not less than 300 MPa. Compared to silicon nitride substrates, aluminum nitride substrates have high thermal conductivities; however, aluminum nitride substrates, which have strengths of less than 500 MPa, are mainstream. Therefore, aluminum nitride substrates are unsuitable when the substrate is thinned. From the perspective of thinning the substrate, a silicon nitride substrate is favorable.

The three-point bending strength is measured using a measurement method in accordance with JIS-R-1601 (2008). The thermal conductivity is measured using a flash method. The fracture toughness value is calculated using Niihara's equation by using a measurement method in accordance with the IF method of JIS-R-1607 (2015). JIS-R-1601 corresponds to ISO 14704. JIS-R-1607 corresponds to ISO 15732.

The metal member 3 is an aluminum member or a copper member. The material of the aluminum member is aluminum, an aluminum alloy, etc. The material of the copper member is pure copper, a copper alloy, etc. Oxygen-free copper is an example of pure copper. Oxygen-free copper is defined in JIS-H-3100. JIS-H-3100 corresponds to ISO 1337, etc. Herein, a copper member that has a plate shape is called a copper plate. When included in a ceramic circuit board, it is favorable for the thickness of the copper plate to be within the range of not less than 0.1 mm and not more than 5 mm.

In the bonded body 1, the nitride ceramic member 2 and the copper member are bonded via the bonding layer 4. The titanium nitride layer 5 that includes titanium nitride as a major component is formed at the interface between the nitride ceramic member 2 and the bonding layer 4.

The bonding layer 4 forms an active metal brazing material by thermal bonding. The active metal brazing material includes titanium (Ti), which is an active metal. In the thermal bonding process, the titanium inside the active metal reacts with nitrogen of the nitride ceramic member to form the titanium nitride layer 5. Therefore, the titanium nitride layer 5 is formed at the interface between the nitride ceramic member 2 and the bonding layer 4.

The titanium nitride layer 5 is a region in which the total of titanium and nitrogen is not less than 70 at%. It is favorable for the titanium nitride layer 5 to be a region in which the total of titanium and nitrogen of the titanium nitride layer 5 is not less than 90 at% and not more than 100 at%. Also, the titanium nitride layer 5 refers to a continuous region of not less than 5 µm in the surface direction of the nitride ceramic member 2 in which the total of titanium and nitrogen is not less than 70 at% and not more than 100 at%.

As described below, regions in which the total of titanium and nitrogen is not less than 70 at% and not more than 100 at% are used as the locations at which the oxygen amount of the titanium nitride layer 5 is measured. It is favorable for the titanium nitride layer 5 to be present in contact with the nitride ceramic member 2.

The measurement of the oxygen amount of the titanium nitride layer 5 is performed in two stages by using TEM-EDX area analysis. The first area analysis is performed to designate the titanium nitride layer 5 of the bonding layer 4. The second area analysis is performed to measure the oxygen amount in a micro region inside the titanium nitride layer 5.

First, the measurement method using TEM-EDX will be described. TEM is a transmission electron microscope (Transmission Electron Microscopy). EDX is energy dispersive X-ray spectroscopy (Energy Dispersive X-ray Spectroscopy). EDX is also called EDS. TEM-EDX analysis is also called simply EDX analysis.

Any cross section of the bonded body 1 is used as the sample for performing EDX analysis. A sample is taken from any cross section by focused-ion beam (FIB) processing or ion milling. It is favorable for the thickness of the sample to be within the range of not less than 0.05 µm and not more than 0.1 µm (not less than 50 nm and not more than 100 nm). To prevent surface oxidation of the sample, it is desirable to make and store the sample in a vacuum or an inert gas atmosphere.

JED-2300T made by JEOL Ltd. or an apparatus having equivalent or better performance is used as the EDX apparatus. JEM-200CX made by JEOL Ltd. (acceleration voltage of 200 kV) or an apparatus having equivalent or better performance is used for TEM. The recommended conditions of EDX analysis are an acceleration voltage of 200 kV and a spot diameter when analyzing of 1 nm. The analysis time is not less than 10 seconds and not more than 15 seconds; and a sample tilt angle of *X* = 0° and Y = 0° is recommended. The orientation of the sample is arbitrary as long as a 20 nm×20 nm measurement region can be ensured.

TEM-EDX is suited to analysis of a micro region. The measurement region 6 is selected from a location separated from the edge surface of the bonding layer by not less than 0.5 mm. There is a possibility that locations within 0.5 mm from the edge surface may be affected by external contamination during storage. The edge surface is the outer edge of the bonding layer of the bonded body, and is a location that directly contacts outside air.

In the first area analysis, the size of the measurement region in the surface direction of the nitride ceramic member 2 is set to be not less than 5 µm. The distribution of titanium and nitrogen is observed in a wide area of the bonding layer 4 in the first area analysis. Based on the distribution of titanium and nitrogen, a continuous region of not less than 5 µm in the surface direction of the nitride ceramic member 2 in which the total of titanium and nitrogen is not less than 70 at% is designated as the titanium nitride layer 5.

In the second area analysis, a 20 nm×20 nm region is selected from the region designated to be the titanium nitride layer 5 in the first area analysis, and is used as the measurement region 6. Any five regions that are separated from each other are selected as the measurement regions. The average values of the ratios of the elements obtained in the five area analyses are calculated. For the average values, the total of the constituent elements other than carbon is taken as 100 at%. Carbon is excluded to remove the effects when the titanium nitride layer 5 reacts with the atmosphere and is carburized by electron beam irradiation when analyzing. When the total of the constituent elements other than carbon is taken as 100 at%, it is favorable for the average value of the oxygen amounts in any five measurement regions to be not less than 1 at%, and for the average value of the nitrogen amounts in the five measurement regions to be not less than 20 at%.

In the first area analysis, the titanium and nitrogen content at points in a wide area are measured. In the second area analysis, the content of each element is measured for the entire 20 nm×20 nm measurement region. The resolution is different between the first area analysis and the second area analysis. Therefore, even for a region designated to be the titanium nitride layer 5 by the first area analysis, there is also a possibility that the total of titanium and nitrogen may be less than 70 at% when the second area analysis is performed. In such a case, measurement regions in which the total of titanium and nitrogen is less than 70 at% are not selected as regions for measuring the nitrogen amount or the oxygen amount.

It is favorable for few regions to be present in the titanium nitride layer 5 in which the total of titanium and nitrogen is measured to be less than 70 at% by the second area analysis. When locations are present at which the total of titanium and nitrogen is measured to be less than 70 at% in the second area analysis, it is favorable for the area ratio of such locations to be not more than 10%, and more favorably not more than 5%. "Area ratio" is represented by the ratio of the number of regions in which the total of titanium and nitrogen is measured to be less than 70 at% to the number of 20 nm×20 nm measurement regions on which the second area analysis is performed. For example, the area ratio is 5% when the second area analysis is performed for twenty measurement regions and when the total of titanium and nitrogen is less than 70 at% in one measurement region among the twenty measurement regions.

The constituent elements other than carbon described above are all elements other than carbon that are detected by TEM-EDX. The constituent elements are components of the nitride ceramic member, components of the active metal brazing material, oxygen, and nitrogen.

For example, when the nitride ceramic member is a silicon nitride sintered body, the constituent elements are Si (silicon), N (nitrogen), and a sintering aid. When the nitride ceramic member is an aluminum nitride sintered body, the constituent elements are Al (aluminum), N (nitrogen), and a sintering aid. When the sintering aid includes yttrium oxide and magnesium oxide, the constituent elements originating in the sintering aid are Y (yttrium), Mg (magnesium), and O (oxygen). When an active metal brazing material that includes Ti (titanium), Ag (silver), Cu (copper), and Sn (tin) is used, the constituent elements originating in the active metal brazing material are Ti, Ag, Cu, and Sn. There may be components of the nitride ceramic member or the active metal brazing material that are not detected (are below the detection limit).

When the total of the constituent elements other than carbon is taken as 100 at%, it is favorable for the average value of the oxygen amounts to be not less than 1 at% and for the average value of the nitrogen amounts to be not less than 20 at% in any five measurement regions. The titanium nitride layer 5 is a region in which the total of titanium and nitrogen is not less than 70 at%. Therefore, the ratio of the constituent elements other than titanium and nitrogen in the titanium nitride layer 5 is less than 30 at%.

The oxygen amount of the titanium nitride layer 5 is not less than 1 at%. The oxygen amount in a 20 nm×20 nm micro measurement region of the titanium nitride layer 5 is not less than 1 at%. The TCT characteristics can be improved thereby.

The titanium nitride layer 5 is formed mainly by titanium of the brazing material and nitrogen of the nitride ceramic reacting. When a continuous furnace is used in the bonding process, there are also cases where nitrogen of the nitrogen atmosphere is incorporated to form the titanium nitride layer 5. It is favorable for the major part of the titanium nitride included in the titanium nitride layer 5 to be a crystalline compound. Amorphous titanium nitride may be present in the titanium nitride layer 5. The titanium nitride layer 5 may be an aggregate of microparticles of titanium nitride. The oxygen that is present in the titanium nitride layer 5 is dissolved in the titanium nitride crystal. The solid solution of oxygen in the titanium nitride crystal is substitutional or interstitial. In either case, there is an upper limit of the solid solution amount. That is, once a certain solid solution amount of the titanium nitride crystal is included, it is difficult for any more oxygen to dissolve in the titanium nitride crystal. Also, oxygen may be present at the grain boundaries of the titanium nitride crystal. The characteristics can be improved by the presence of a prescribed amount of oxygen in the titanium nitride layer 5.

In the results of the area analysis, it is more favorable for the average value of the nitrogen amounts to be within the range of not less than 50 at% and not more than 65 at% and for the average value of the oxygen amounts to be within the range of not less than 1 at% and not more than 10 at% in any five measurement regions. TiN is a compound of which the atomic ratio of Ti to N is 1:1. The nitrogen amount of the titanium nitride layer 5 being not less than 50 at% indicates that the titanium nitride layer 5 includes more nitrogen than TiN.

When the average value of the nitrogen amounts is less than 20 at%, there is a possibility that the reaction between the nitride ceramic member and Ti (the Ti of the active metal brazing material) may be insufficient. When the reaction is insufficient, there is a possibility that the bonding strength may decrease. When the average value of the nitrogen amounts is greater than 65 at%, there is a possibility that there may be too much nitrogen; the titanium nitride layer 5 may become unstable; and the bonding strength may decrease. When the titanium nitride layer 5 becomes unstable, there is a possibility that it may be difficult to maintain a stable TiN crystal and/or Ti-N-O compound. Also, there is a possibility that the reaction between the nitride ceramic member and the Ti may not proceed properly. It is therefore favorable for the average value of the nitrogen amounts to be within the range of not less than 50 at% and not more than 65 at%, and more favorably within the range of not less than 51 at% and not more than 62 at%. Also, when the average value of the oxygen amounts is greater than 10 at%, there is a possibility that the titanium nitride layer 5 may destabilize, and the bonding strength may be reduced. It is therefore favorable for the average value of the oxygen amounts to be within the range of not less than 1 at% and not more than 10 at%, and more favorably within the range of not less than 1.5 at% and not more than 7 at%.

In the results of the area analysis, it is favorable for the nitrogen amount to be within the range of not less than 50 at% and not more than 65 at% and for the oxygen amount to be within the range of not less than 1 at% and not more than 10 at% for each of the arbitrary five measurement regions. That is, in the region of the titanium nitride layer 5 in which the total of titanium and nitrogen is not less than 70 at%, it is favorable for the oxygen amount in each of the 20 nm×20 nm measurement regions to be within the range of not less than 1 at% and not more than 10 at%. This indicates that titanium nitride in which oxygen is dissolved is present in each micro region. The characteristics can be further improved by oxygen being present in each 20 nm×20 nm micro region.

It is favorable for the titanium nitride layer 5 to include a Ti-N-O compound. It is favorable for the Ti-N-O compound to be a solid solution in which oxygen is dissolved in titanium nitride. The presence of the Ti-N-O compound can be measured by the TEM-EDX described above. The atomic ratio of Ti, N, and O in the Ti-N-O compound is arbitrary. Examples of the Ti-N-O compound include TiNₓO₍₁₋ₓ₎ in which 0.2 ≤ *x* ≤ 1.0 such as TiN_{0.5}O_{0.5}, etc. It is favorable for the Ti-N-O compound that satisfies this chemical formula to be not less than 90 atomic% among the Ti-N-O compounds included in the titanium nitride layer 5. Also, the Ti-N-O compound may include components other than Ti, N, and O as constituent elements such as in the TiN-O-Si.

It is considered that the Ti-N-O compound is detected because a more uniform distribution of the oxygen amount is achieved. Also, by forming the Ti-N-O compound, degradation of the titanium nitride layer 5 due to oxidization can be suppressed. In other words, the presence as a Ti-N-O compound beforehand can prevent new oxidization of the titanium nitride layer. Oxygen that is not included in the Ti-N-O compound may be present in the titanium nitride layer 5.

Also, it is favorable for the oxygen of the substances included in the titanium nitride layer 5 to be dissolved based on the Fm-3m space group structure (e.g., TiN: JCPDS card 00-038-1420 or Ti-N-OJCPDS card 00-049-1325) having a sodium chloride structure. It is favorable for the plane spacing of the titanium nitride in which oxygen is dissolved as measured by the TEM electron diffraction to be greater than the plane spacing of the card. For example, for the (111) plane of the 00-038-1420 TiN phase, it is favorable for the plane spacing to be not less than 0.00001/nm, and more favorably not less than 0.001/nm.

It is favorable for the thickness of the titanium nitride layer 5 to be within the range of not less than 0.1 µm and not more than 2 µm. When the thickness of the titanium nitride layer 5 is less than 0.1 µm, there is a possibility that the bonding strength may be insufficient. When the titanium nitride layer 5 is thick and is greater than 2 µm, there is a possibility that no further effects can be obtained. It is therefore favorable for the thickness of the titanium nitride layer 5 to be within the range of not less than 0.1 µm and not more than 2 µm, and more favorably within the range of not less than 0.2 µm and not more than 1 µm. The thickness of the titanium nitride layer 5 is the thickness along a straight line from the nitride ceramic substrate toward the copper plate.

It is favorable for the thickness of the bonding layer 4 to be within the range of not less than 5 µm and not more than 40 µm. When the thickness of the bonding layer 4 is less than 5 µm, there is a possibility that the bonding strength may be insufficient. When the bonding layer 4 is thick and is greater than 40 µm, there is a possibility that no further effects can be obtained. It is therefore favorable for the thickness of the bonding layer 4 to be within the range of not less than 5 µm and not more than 40 µm, and more favorably within the range of not less than 10 µm and not more than 30 µm.

The titanium nitride layer 5 may include titanium nitride particles having an average particle size of not more than 100 nm. The titanium nitride particles may be Ti-N-O compound particles. The distribution of the oxygen amount is easily controlled by the presence of the titanium nitride particles. It is therefore favorable for the average particle size of the titanium nitride particles to be not more than 100 nm, and more favorably not more than 20 nm. Although not particularly limited, it is favorable for the lower limit of the average particle size of the titanium nitride particles to be not less than 5 nm. When the average particle size is less than 5 nm, there is a possibility that the thickness of the titanium nitride layer may be insufficient. It is therefore favorable for the average particle size of the titanium nitride particles to be within the range of not less than 5 nm and not more than 100 nm, and more favorably within the range of not less than 10 nm and not more than 20 nm. The average particle size of the titanium nitride particles is measured by TEM observation. The major diameters of the titanium nitride particles are measured by TEM observation; and the average value of any twenty major diameters is used as the average particle size.

It is favorable for the bonding layer 4 to include at least one selected from the group consisting of Ti, Cu, and Ag and at least one selected from the group consisting of Sn, In, and C. The bonding layer 4 includes the titanium nitride layer 5. The titanium nitride layer 5 is a region in which the total of titanium and nitrogen is not less than 70 at%. A region in which the total of titanium and nitrogen is less than 70 at% is formed between the titanium nitride layer 5 and the copper member. It is favorable for the region in which the total of titanium and nitrogen is less than 70 at% to include at least one selected from the group consisting of Cu and Ag and at least one selected from the group consisting of Sn, In, and C. These elements contribute to the improvement of the bonding strength with the copper member. Also, when the bonded body is included in the ceramic circuit board, the region of the bonding layer 4 including these elements also can be included in the bonding layer jutting part. The TCT characteristics can be improved by forming the bonding layer jutting part.

It is favorable to add, as components of the active metal brazing material, at least one selected from the group consisting of Ti, Cu, and Ag and at least one selected from the group consisting of Sn, In, and C. By using the active metal brazing material including these elements, the bonding layer 4 that includes at least one selected from the group consisting of Ti, Cu, and Ag and at least one selected from the group consisting of Sn, In, and C is obtained.

Examples of the components of the active metal brazing material include not less than 1 mass% and not more than 15 mass% of Ti (titanium) or TiH₂ (titanium hydride), not less than 15 mass% and not more than 85 mass% of Cu (copper), and not less than 0 mass% and not more than 70 mass% of Ag (silver). At least one selected from Sn (tin) and In (indium) may be included within the range of not less than 1 mass% and not more than 50 mass%; and C (carbon) may be included within the range of not less than 0.1 mass% and not more than 2 mass%.

Ti (titanium) is a component that reacts with the nitride ceramic member to form the titanium nitride layer 5. Ti may be added as TiH₂ (titanium hydride). It is favorable for the content of Ti or TiH₂ to be within the range of not less than 5 mass% and not more than 15 mass%. By increasing the Ti amount to be not less than 5 mass%, oxygen is easily incorporated into the titanium nitride layer.

Cu and Ag are major components of the bonding layer 4. When both Ag and Cu are included, it is favorable for the Ag content to be within the range of not less than 20 mass% and not more than 60 mass%, and for the Cu content to be within the range of not less than 15 mass% and not more than 40 mass%. The active metal brazing material may not include Ag.

Sn and In have the effect of lowering the melting point of the brazing material. Also, Sn and In have the effect of improving the TCT characteristics by alloying with Cu. Carbon is a component for controlling the fluidity of the brazing material. The control of the fluidity of the brazing material is effective to partially disperse the brazing material components.

At least one selected from tungsten (W), molybdenum (Mo), and rhenium (Re) may be added to the active metal brazing material within the range of not less than 0.1 mass% and not more than 10 mass%. The fluidity of the active metal brazing material can be controlled by adding at least one of carbon, tungsten, molybdenum, or rhenium. Magnesium (Mg) may be added to the active metal brazing material.

The content of the brazing material components is calculated using the total of the constituent components of the brazing material as 100 mass%. The content of the brazing material components does not include a binder, a solvent, etc., for making the brazing material paste.

By using the active metal brazing material, the titanium nitride layer 5 and the brazing material layer 7 are formed in the bonding layer 4 as shown in FIG. 2. The brazing material layer 7 is a region of the bonding layer 4 in which the total of titanium and nitrogen is less than 70 at%, and is positioned between the titanium nitride layer 5 and the metal member 3. The Ti-rich region 9 may be present in the brazing material layer 7. A major component of the brazing material layer 7 is a component of the active metal brazing material. Therefore, titanium components also are distributed in the brazing material layer 7. The titanium components that are inside the brazing material layer 7 are titanium that did not become the titanium nitride layer 5.

When the bonding layer 4 includes the titanium nitride layer 5 and the brazing material layer 7, and when the brazing material layer 7 is analyzed, the brazing material layer 7 includes the Ti-rich region 9 including not less than 30 at% of Ti. It is favorable for the nitrogen amount of the Ti-rich region 9 to be within the range of not less than 1 at% and not more than 15 at%. The brazing material layer 7 may include a region other than the Ti-rich region 9. For example, the brazing material layer 7 may include a Ti-poor region including not less than 0 at% but less than 30 at% of Ti.

Analysis by TEM-EDX can be used to analyze the brazing material layer 7. Specifically, first, surface analysis of the brazing material layer 7 is performed using EDX. A region that includes not less than 30 at% of Ti is designated as the Ti-rich region 9 based on the results of the surface analysis. The content of the elements included in the Ti-rich region 9 can be measured by setting a measurement region inside the designated Ti-rich region 9 and by analyzing the measurement region using TEM-EDX. For example, the size of the measurement region is set to 20 nm×20 nm.

The nitrogen amount of the Ti-rich region 9 of the brazing material layer 7 is less than the nitrogen amount of the titanium nitride layer 5. The TCT characteristics can be improved thereby. Also, it is favorable for the oxygen amount of the Ti-rich region 9 to be within the range of not less than 0 at% and not more than 3 at%. By reducing the oxygen amount of the Ti-rich region 9, the oxygen amount of the titanium nitride layer 5 can be controlled to be within the prescribed range. In other words, the oxygen amount of the Ti-rich region 9 can be reduced by setting the oxygen amount of the titanium nitride layer 5 to be within the prescribed range.

The Ti-rich region 9 includes Ti and active metal brazing material components other than Ti. For example, when a CuSnTi brazing material is used as the active metal brazing material, the Ti-rich region 9 may include one or two of Cu or Sn. Although not particularly limited, it is favorable for the upper limit of the Ti amount of the Ti-rich region 9 to be not more than 50 at%. When the Ti amount is high and is greater than 50 at%, the ratio of the components other than Ti in the active metal brazing material is reduced. It is therefore favorable for the Ti amount in the Ti-rich region 9 to be within the range of not less than 30 at% and not more than 50 at%, and more favorably within the range of not less than 33 at% and not more than 46 at%.

It is favorable for the Ti-rich region 9 to include one selected from Sn or In within the range of not less than 20 at% and not more than 40 at%. Also, it is favorable for the Ti-rich region 9 to include Cu within the range of not less than 0 at% and not more than 20 at%. In the Ti-rich region, when the sum of the contents of Ti, Sn, Cu, N, and O is taken as 100 at%, it is favorable for the Ti content to be not less than 30 at% and not more than 50 at%, for the Sn content to be not less than 20 at% and not more than 40 at%, for the Cu content to be not less than 0 at% and not more than 20 at%, for the nitrogen content to be not less than 1 at% and not more than 15 at%, and for the oxygen content to be not less than 0 at% and not more than 3 at%. The Ti-rich region 9 satisfying these composition ranges indicates that the major component of the Ti-rich region 9 is a SnTi alloy phase. That is, nitrogen is present in the SnTi alloy phase. Sn is replaced with In when In is used instead of Sn. That is, the major component of the Ti-rich region 9 is an InTi alloy phase.

It is favorable for the area ratio of the Ti-rich region 9 to be within the range of not less than 5% and not more than 30% of the bonding layer 4. SEM-EDX is used to measure the area ratio of the Ti-rich region 9. Field Emission SEM (FE-SEM) may be used as SEM. JSM-7200F made by JEOL Ltd. or an apparatus having equivalent performance is used for FE-SEM. EX-74600U4L2Q made by JEOL Ltd. or an apparatus having equivalent performance is used for EDX.

Here, an example of a bonded body is described in which a copper member is used as the metal member 3, and a nitride ceramic substrate is used as the nitride ceramic member 2. Any cross section of the bonding layer 4 is observed in FE-SEM. The cross section is a surface parallel to the thickness direction. The thickness direction is perpendicular to the surface of the nitride ceramic substrate, and is parallel to the direction connecting the nitride ceramic substrate and the copper member. The measurement conditions of FE-SEM are set to an acceleration voltage of 15 kV and a magnification of 3,000 times. The field area is set to the bonding layer thickness×40 µm in the width direction. For example, when the thickness of the bonding layer 4 is 30 µm, the field area is set to 30 µm in the thickness direction×40 µm in the width direction. The width direction is parallel to the surface of the nitride ceramic substrate and perpendicular to the thickness direction.

The measurement conditions of EDX are set to 50 scans and a dwell time of 0.2 ms. The dwell time is the measurement speed per pixel. When performing EDX area analysis, the number of pixels acquired is set to 256 pixels wide×198 pixels long; the detection count is set to 3,700 to 4,100 cps (Count Per Second); and the quantitative map is set to 5×5 bit/point. Point analysis is analysis using the result of measuring one detection count (one location). Area analysis is analysis that uses the results of measuring multiple detection counts. Area analysis also is called surface analysis.

EDX analysis may be performed after clarifying designated elements by measuring the elements included in the bonding layer 4 beforehand. For example, when Cu (copper), Sn (tin), Ti (titanium), Si (silicon), O (oxygen), and N (nitrogen) are detected as the elements included in the bonding layer 4, these elements are set as the designated elements. The results of the area analysis are used to map the designated elements. For example, the titanium nitride layer 5 of the bonding layer 4 is designated based on the mapping results of Ti and N. As described above, a continuous region of not less than 5 µm in the surface direction of the nitride ceramic member 2 in which the total of titanium and nitrogen is not less than 70 at% and not more than 100 at% is designated as the titanium nitride layer 5. The region of the bonding layer 4 other than the titanium nitride layer 5 is the brazing material layer 7. The Ti-rich region 9 is designated based on the Ti mapping result of the brazing material layer 7. The area ratio of the Ti-rich region 9 can be calculated by measuring the area of the bonding layer 4 and the area of the Ti-rich region 9. The accessory functions of SEM-EDX are used for SEM-EDX mapping. Image software is used for the mapping when a mapping function is not included.

The area ratio is calculated by performing area analysis of three regions using EDX and by using the average value of the three regions. The area (the field area) of one region is the bonding layer thickness×40 µm in the width direction. The measurement field is matched to the bonding layer 4. Any three mutually-adjacent regions are selected from the cross section of the bonding layer 4; and each of the three regions is analyzed. The bonding layer 4 is the range from the boundary between the nitride ceramic substrate and the bonding layer 4 to the boundary between the bonding layer 4 and the copper member.

The boundary between the nitride ceramic substrate and the bonding layer 4 is the bonding interface between the nitride ceramic substrate surface and the titanium nitride layer 5. For example, when a silicon nitride substrate is used, the bonding interface between the silicon nitride substrate and the titanium nitride layer is the boundary between the nitride ceramic substrate and the bonding layer 4. The boundary between the bonding layer 4 and the copper member is defined by using the Ti amount as a reference. At the boundary vicinity between the bonding layer 4 and the copper member, the Ti amount decreases from the bonding layer 4 toward the surface of the copper member. The boundary is defined based on locations of continuous regions of 50 µm in the width direction in which the Ti amount is not more than 1 atomic%. When multiple such locations are present, the boundary between the bonding layer 4 and the copper member is defined based on the location among the multiple locations most proximate to the bonding layer 4 (the nitride ceramic substrate).

In the bonded body, the copper plates may be bonded respectively to two surfaces of the nitride ceramic member via the bonding layers. When the copper plates are bonded to two surfaces, it is favorable for the titanium nitride layers 5 at the two surfaces to have the characteristics described above.

The bonded body according to the embodiment can be used in a ceramic circuit board. FIG. 3 is a side view showing an example of a ceramic circuit board according to an embodiment. In FIG. 3, the reference numeral 10 is a ceramic circuit board, the reference numeral 11 is a circuit part (a front copper plate), and the reference numeral 12 is a heat dissipation plate (a back copper plate). The circuit part 11 is obtained by providing a circuit configuration in the metal member. Or, the ceramic circuit board 10 may be obtained by bonding, to the nitride ceramic member 2, a metal member that is patterned into a circuit configuration.

The ceramic circuit board 10 illustrated in FIG. 3 includes two circuit parts 11. Three or more circuit parts 11 may be located at the nitride ceramic member 2. Also, in the example shown in FIG. 3, the circuit part 11 is located at the front surface of the nitride ceramic member 2; and the heat dissipation plate 12 is located at the back surface of the nitride ceramic member 2. The configuration is not limited to the example; and the circuit parts 11 may be located respectively at the two surfaces of the nitride ceramic member 2. As necessary, an inclined shape can be provided in the side surface of the circuit part 11 and the side surface of the heat dissipation plate 12. Also, the bonding layer 4 may include a jutting part jutting from the end portion of the circuit part 11 or the end portion of the heat dissipation plate 12 as necessary.

FIG. 4 is a side view showing an example of a semiconductor device according to an embodiment. In FIG. 4, the reference numeral 10 is a ceramic circuit board, the reference numeral 14 is a semiconductor element, and the reference numeral 20 is a semiconductor device. The semiconductor device 20 is obtained by mounting the semiconductor element 14 to the circuit part 11. Metal terminals, wire bonding, or resin sealing may be provided as necessary when making the semiconductor device 20.

The ceramic circuit board 10 according to the embodiment has good TCT characteristics. In recent years, junction temperatures have increased as the performance of the semiconductor element 14 has increased. The junction temperature of a SiC element is about 200 °C.

The bonded body 1 according to the embodiment suppresses further degradation of the titanium nitride layer 5 due to oxidization. Oxidization occurs easily in a high-temperature environment or in an environment of high humidity. According to the embodiment, oxidization of the titanium nitride layer 5 due to high temperature or moisture can be suppressed. For example, in addition to the heat generation amount of the semiconductor element, there are cases where semiconductor devices used in automobiles or industrial devices are used in environments of high moisture. Therefore, further degradation due to oxidization occurs more easily. According to the embodiment, degradation due to oxidization of the titanium nitride layer can be suppressed, and so the bonded body can be used in various environments.

A method for manufacturing a bonded body according to an embodiment will now be described. The method for manufacturing the bonded body according to the embodiment is not particularly limited as long as the bonded body has the configuration described above. An example of a method for obtaining the bonded body according to the embodiment with a high yield will now be described.

First, a nitride ceramic member is prepared. It is favorable for the nitride ceramic member to be a silicon nitride substrate or an aluminum nitride substrate. Also, a copper plate is prepared as the metal member. It is favorable for the copper plate to be an oxygen-free copper plate or a copper alloy plate.

Then, an active metal brazing material is prepared. It is favorable for the active metal brazing material to include at least one selected from the group consisting of Ti, Cu, and Ag and at least one selected from the group consisting of Sn, In, and C. Ti alone or TiH₂ (titanium hydride) may be added as Ti. The mixing ratio of the elements in the active metal brazing material is as described above. An active metal brazing material paste is made by mixing the brazing material components and then adding a binder, etc., to the mixture. The binder is, for example, an organic binder.

An active metal brazing material layer is formed by coating the active metal brazing material paste on the nitride ceramic member. A copper plate is placed on the active metal brazing material layer. When copper plates are bonded to two surfaces of the nitride ceramic member, an active metal brazing material layer is formed on one more surface as well, and a copper plate is placed on the active metal brazing material layer. The configuration of the active metal brazing material layer and the copper plate placed on the nitride ceramic member is called a stacked body.

A process of thermally bonding the stacked body is performed. A bonded body is made by thermally bonding the stacked body. Also, the thermal bonding causes the active metal brazing material layer to become a bonding layer. It is favorable to use a continuous furnace in the thermal bonding process. A continuous furnace is a furnace in which the heating object is heated while being conveyed. For example, International Publication No. 2022/244769 (Patent Literature 5) discusses a method for manufacturing a bonded body that uses a continuous furnace. According to the invention described in Patent Literature 5, a bonded body can be obtained with a high yield by controlling the temperature raising rate and the temperature lowering rate.

To control the oxygen amount inside the titanium nitride layer, it is effective to control the oxygen amount of the atmosphere in the thermal bonding process. A continuous furnace is used in the thermal bonding process. The interior of the continuous furnace is controlled to be a nitrogen atmosphere. It is favorable for the oxygen concentration in the nitrogen atmosphere to be within the range of not less than 10 volppm and not more than 1,000 volppm. By controlling the oxygen amount in the nitrogen atmosphere, oxygen is incorporated into the titanium nitride layer formed in the heating process. When the oxygen concentration is less than 10 volppm, there is a possibility that the oxygen in the titanium nitride layer may be insufficient. Also, when the oxygen concentration is greater than 1,000 volppm, a region in which the total of titanium and nitrogen is less than 70 at% is easily formed. It is therefore favorable for the oxygen amount in the nitrogen atmosphere to be within the range of not less than 10 volppm and not more than 1,000 volppm, and more favorably within the range of not less than 50 volppm and not more than 200 volppm. Oxygen gas may be supplied in addition to nitrogen gas as necessary to control the oxygen amount in the nitrogen atmosphere.

It is favorable for the concentration of carbon monoxide (CO) in the nitrogen atmosphere to be not more than 1,000 volppm (0.1 vol%). CO is reductive. Therefore, there is a possibility that CO may inhibit the incorporation of oxygen into titanium nitride. It is favorable for the CO concentration to be not more than 1,000 volppm, and more favorably not more than 100 volppm.

As described above, an organic binder is added to the active metal brazing material paste. In the thermal bonding process, there are cases where CO gas is generated as the organic binder disappears. The continuous furnace is suited to mass production because the bonded body can be continuously processed. It is effective to exhaust the space inside the continuous furnace so that the CO gas generated from the bonded body does not remain.

When the thermal bonding zone of the continuous furnace is sufficiently exhausted, the oxygen amount in the nitrogen atmosphere is substantially equal to the oxygen amount included in the nitrogen gas supplied to the thermal bonding zone. Similarly, the CO amount in the nitrogen atmosphere also is substantially equal to the CO amount included in the nitrogen gas supplied to the thermal bonding zone. Accordingly, it is favorable for the oxygen amount of the nitrogen gas supplied to the thermal bonding zone to be within the range of not less than 10 volppm and not more than 1,000 volppm, and for the CO amount of the nitrogen gas to be not more than 1,000 volppm.

The continuous furnace performs thermal bonding while conveying the stacked body. The interior of the continuous furnace is divided into multiple processing zones according to the temperature range. For example, multiple processing zones such as a room temperature zone, a temperature raising zone, a thermal bonding zone, a temperature lowering zone, etc., are provided. The room temperature zone is the area at which the conveyance of the stacked body into the continuous furnace is started. Also, in the temperature raising zone, the temperature of the stacked body is raised in stages to the bonding temperature. In the thermal bonding zone, the temperature of the stacked body is held at the heating temperature. In the temperature lowering zone, the temperature of the stacked body is lowered in stages. In the temperature raising zone, it is favorable for the average temperature raising rate from 200 °C to the bonding temperature to be within the range of not less than 15 °C/min and not more than 200 °C/min. In the temperature lowering zone, it is favorable for the average temperature lowering rate from the bonding temperature to 200 °C to be within the range of not less than 15 °C/min and not more than 200 °C/min.

For example, when the bonding temperature is within the range of not less than 650 °C and not more than 980 °C, the temperature of the stacked body is held within the range of not less than 650 °C and not more than 980 °C in the thermal bonding zone. At this time, it is effective to supply nitrogen gas in which the oxygen amount is controlled to the thermal bonding zone. Also, the oxygen amount of the nitrogen gas supplied to the temperature raising zone may be controlled. Gas is generated due to the heating inside the continuous furnace as the binder is removed from the brazing material layer. By supplying nitrogen gas in which the oxygen amount is controlled while exhausting the temperature raising zone, the effects of the gas generated from the brazing material layer on the oxygen concentration of the titanium nitride layer 5 can be reduced.

In the thermal bonding zone, it is favorable for the nitrogen gas flow rate to be not less than 2 liter/min. When thermal bonding is performed, gases such as CO, hydrocarbons (CH-based), etc., are generated from the brazing material layer. By controlling the nitrogen gas flow rate, the gas that is generated from the brazing material layer can be removed without remaining. It is therefore favorable for the nitrogen gas flow rate to be not less than 2 liter/min, and more favorably not less than 30 liter/min. Although not particularly limited, it is favorable for the upper limit of the nitrogen gas flow rate to be not more than 400 liter/min. When the airflow rate is greater than 400 liter/min, there is a possibility that the airflow rate may be too strong, which may cause misalignment of the stacked body being conveyed. It is therefore favorable for the nitrogen gas flow rate to be within the range of not less than 2 liter/min and not more than 400 liter/min, and more favorably within the range of not less than 30 liter/min and not more than 300 liter/min.

It is favorable to similarly control the nitrogen gas flow rate supplied to the temperature raising zone. This is because gases such as CO, hydrocarbons, etc., may be generated by the organic binder volatilizing in the temperature raising zone as well. It is favorable to similarly control the nitrogen gas flow rate of the temperature lowering zone as well. There is a possibility that the titanium nitride layer 5 may be affected by gases such as CO, hydrocarbons, etc., generated by the organic binder volatilizing directly after the thermal bonding zone.

It is favorable to control the conveyance speed of the stacked body in the temperature lowering zone. It is favorable for the conveyance speed in the temperature lowering zone from 650 °C to 400 °C to be within the range of not less than 1 cm/min and not more than 15 cm/min. For example, the conveyance speed in the temperature lowering zone from 400 °C to 200 °C may be within the range of not less than 15 cm/min and not more than 100 cm/min. In other words, in the temperature lowering zone, the conveyance speed in the prescribed temperature range is slower than the conveyance speed in the other temperature ranges. The conveyance speed may be increased when the temperature is less than 400 °C in the temperature lowering zone due to little effect on the bonded body. Although the conveyance speed may be low, it cannot be said to be good for the productivity because the total processing time increases.

In the bonding process using the active metal brazing material, the active metal brazing material melts in the temperature raising zone. As the active metal brazing material melts, a reaction occurs between the active metal brazing material and the nitride ceramic member; and the titanium nitride layer is formed. In the temperature lowering zone, the bonding layer that includes the titanium nitride layer is solidified. Oxygen is easily incorporated into the titanium nitride layer by reducing the conveyance speed in the process of solidifying the titanium nitride layer. As described above, oxygen is incorporated into the titanium nitride layer in the thermal bonding process. If too much oxygen is incorporated in the temperature raising zone, there is a possibility that the bonding may be unfavorably affected. In the temperature lowering zone, the bonding layer is in the solidifying stage, and so the incorporation of more oxygen than necessary can be suppressed. When the conveyance speed is less than 1 cm/min (including 0 cm/min), the conveyance speed is too slow, and there is a possibility that the contact time with the oxygen in the nitrogen atmosphere may increase.

Also, the conveyance speeds in zones other than the temperature lowering zone are arbitrary as long as the temperature of the stacked body is controllable. The conveyance speed may be within the range of not less than 1 cm/min and not more than 15 cm/min, and may be greater than 15 cm/min. Although not particularly limited, it is favorable for the upper limit of the conveyance speed to be not more than 30 cm/min. When the conveyance speed is greater than 30 cm/min, it may be necessary to lengthen the temperature raising zone and/or the thermal bonding zone. This is unfavorable because it may result in a larger continuous furnace.

The oxygen amount in the titanium nitride layer can be controlled using the oxygen amount in the nitrogen atmosphere, the carbon monoxide amount in the nitrogen atmosphere, the flow rate of the nitrogen gas, the conveyance speed, etc. Any one of these conditions may be used alone, or multiple conditions may be combined. By combining multiple conditions, further control of the oxygen amount in the titanium nitride layer is easier.

The bonded body can be obtained by the processes described above. Subsequently, the ceramic circuit board is obtained by providing the circuit configuration in the copper plate of the bonded body. It is favorable to use an etching process in the process of providing the circuit configuration. Also, the stacked body may be made using a copper plate in which a circuit configuration is provided beforehand. An etching process is effective when providing the side surface of the copper plate with an inclined shape, and even when forming a jutting part in the bonding layer. From the perspective of providing the inclined shape and forming the jutting part as well, it is favorable for the process of providing the circuit configuration to be an etching process.

### (Examples)

### (Examples 1 to 6 and comparative examples 1 to 4)

A silicon nitride substrate and an aluminum nitride substrate were prepared as nitride ceramic members. The thermal conductivity of the silicon nitride substrate was 90 W/m·K. The three-point bending strength was 600 MPa. The size was 200 mm long×150 mm wide×0.32 mm thick. The thermal conductivity of the aluminum nitride substrate was 170 W/m·K. The three-point bending strength was 400 MPa. The size was 150 mm long×100 mm wide×0.635 mm thick. Oxygen-free copper plates were used as the copper plates. The thicknesses of the copper plates were as shown in Table 1. Also, the active metal brazing materials shown in Table 2 were prepared.

**[Table 1]**

| | Thickness |
|---|---|
| Copper plate 1 | 0.6mm |
| Copper plate 2 | 0.8mm |
| Copper plate 3 | 0.3mm |

**[Table 2]**

| Active metal brazing material | Composition (mass%) |
|---|---|
| Brazing material 1 | Ag(45), Cu(35). Sn(15). Ti(5) |
| Brazing material 2 | Ag(43.9). Cu(37), Sn(10), Ti(9), C(0.1) |
| Brazing material 3 | Cu(70). Sn(22). Ti(8) |
| Brazing material 4 | Cu(67.9), Sn(26), Ti(6), C(0.1) |
| Brazing material 5 | Ag(55), Cu(35), Sn(8), Ti(2) |

An active metal brazing material paste was made by adding a binder, etc., to the active metal brazing material. Active metal brazing material layers were formed by coating the active metal brazing material paste on two surfaces of the silicon nitride substrate. Copper plates were placed respectively on the active metal brazing material layers. A stacked body was made by these processes. The stacked body included the silicon nitride substrate, the active metal brazing material layers respectively formed on the two surfaces of the silicon nitride substrate, and the copper plates placed respectively on the active metal brazing material layers. The combinations of the stacked bodies were as shown in Table 3.

**[Table 3]**

| | Stacked body | Ceramic substrate | Front side | | Backside | |
|---|---|---|---|---|---|---|
| | | | Copper plate | Active metal brazing material | Copper plate | Active metal brazing material |
| Example 1 | Stacked body 1 | Si₃N₄ | Copper plate 1 | Brazing material 1 | Copper plate 1 | Brazing material 1 |
| Example 2 | Stacked body 2 | Si₃N₄ | Copper plate 2 | Brazing material 2 | Copper plate 2 | Brazing material 2 |
| Example 3 | Stacked body 3 | Si₃N₄ | Copper plate 1 | Brazing material 3 | Copper plate 1 | Brazing material 3 |
| Example 4 | Stacked body 4 | Si₃N₄ | Copper plate 2 | Brazing material 4 | Copper plate 2 | Brazing material 4 |
| Example 5 | Stacked body 6 | AIN | Copper plate 3 | Brazing material 2 | Copper plate 3 | Brazing material 2 |
| Example 6 | Stacked body 7 | AIN | Copper plate 3 | Brazing material 4 | Copper plate 3 | Brazing material 4 |
| Comparative example 1 | Stacked body 5 | Si₃N₄ | Copper plate 1 | Brazing material 5 | Copper plate 1 | Brazing material 5 |
| Comparative example 2 | Stacked body 5 | Si₃N₄ | Copper plate 1 | Brazing material 5 | Copper plate 1 | Brazing material 5 |
| Comparative example 3 | Stacked body 8 | AIN | Copper plate 3 | Brazing material 5 | Copper plate 3 | Brazing material 5 |
| Comparative example 4 | Stacked body 9 | AIN | Copper plate 3 | Brazing material 5 | Copper plate 3 | Brazing material 5 |

Then, a bonded body was obtained by using a continuous furnace to thermally bond the stacked body for the examples 1 to 6, the comparative example 1, and the comparative example 3. A bonded body was obtained by thermal bonding using a vacuum furnace (a batch furnace) for the comparative examples 2 and 4.

In the continuous furnace, the bonding temperature of the thermal bonding zone was set to be within the range of not less than 750 °C and not more than 980 °C. The temperature raising rate from 200 °C to the bonding temperature was set to 20 °C/min. The temperature lowering rate from the bonding temperature to 200 °C was set to 20 °C/min. The characteristics of the nitrogen gas supplied to the thermal bonding zone were as shown in Table 4. The nitrogen gas flow rate was set to be within the range of not less than 30 liter/min and not more than 300 liter/min in each of the temperature raising zone, the thermal bonding zone, and the temperature lowering zone for the examples. The conveyance speed of the temperature lowering zone was set to be within the range of not less than 1 cm/min and not more than 15 cm/min for the examples. The nitrogen gas flow rate was set to 1 liter/min in each of the temperature raising zone, the thermal bonding zone, and the temperature lowering zone for the comparative examples 1 and 3. The conveyance speed of the temperature lowering zone was set to 35 cm/min for the comparative examples 1 and 3. The batch furnace was used to perform bonding with a bonding temperature of 850 °C in a vacuum (not more than 10⁻³ Pa) for the comparative examples 2 and 4.

**[Table 4]**

| | Nitrogen gas (volppm) | | | | | |
|---|---|---|---|---|---|---|
| | Temperature raising zone | | Thermal bonding zone | | Temperature lowering zone | |
| | Oxygen amount | Total amount of CO₂ and CO | Oxygen amount | Total amount of CO₂ and CO | Oxygen amount | Total amount of CO₂ and CO |
| Example 1 | 250 | ≦ 10 | 250 | ≦ 10 | 250 | ≦ 10 |
| Example 2 | 300 | ≦ 10 | 300 | ≦ 10 | 300 | ≦ 10 |
| Example 3 | 120 | ≦ 10 | 120 | ≦ 10 | 120 | ≦ 10 |
| Example 4 | 70 | ≦ 100 | 70 | ≦ 100 | 70 | ≦ 10 |
| Example 5 | 350 | ≦ 10 | 200 | ≦ 10 | 350 | ≦ 10 |
| Example 6 | 200 | ≦ 10 | 200 | ≦ 10 | 200 | ≦ 10 |
| Comparative example 1 | 5 | 300 | 5 | 300 | 5 | 300 |
| Comparative example 3 | 5 | 300 | 5 | 300 | 5 | 300 |

The bonded bodies according to the examples and the comparative examples were obtained by the processes described above. Then, cross sections of the bonded bodies were analyzed using TEM-EDX. A titanium nitride layer that included titanium nitride as a major component was observed in each of the bonded bodies according to the examples and the comparative examples. In other words, a continuous region of not less than 5 µm in the surface direction of the nitride ceramic substrate in which the total of titanium and nitrogen was not less than 70 at% was observed.

Then, any five mutually-separated 20 nm×20 nm measurement regions were selected from the titanium nitride layer of each of the examples and the comparative examples. Area analysis of the selected measurement regions was performed using TEM-EDX. The average value of the nitrogen amounts in the five measurement regions, the average value of the oxygen amounts in the five measurement regions, and the minimum value and maximum value of the oxygen amounts in the five measurement regions were obtained for each of the examples and the comparative examples. The oxygen amount and the nitrogen amount were calculated by using the total of the constituent elements other than carbon as 100 at%. Also, the thickness of the titanium nitride layer and the presence of a TiN-O compound were measured. The results are shown in Table 5.

**[Table 5]**

| | Titanium nitride layer | | | | |
|---|---|---|---|---|---|
| | Average value of nitrogen amounts(at%) | Oxygen amount (at%) | | Thickness (µm) | Ti-N-O compound |
| | | Average value | Minimum value ~ maximum value | | |
| Example 1 | 62 | 6.7 | 5.5~7.3 | 1.7 | Present |
| Example 2 | 60 | 6.3 | 5.1~7.0 | 1.6 | Present |
| Example 3 | 53 | 2.7 | 2.2~3.2 | 1.5 | Present |
| Example 4 | 52 | 2.4 | 1.8~2.8 | 1.4 | Present |
| Example 5 | 59 | 6.4 | 5.0~7.2 | 1.7 | Present |
| Example 6 | 53 | 2.6 | 1.8~2.9 | 1.5 | Present |
| Comparative example 1 | 52 | 0.5 | 0-1.1 | 1.5 | Present |
| Comparative example 2 (Batch furnace) | 48 | 0 | 0 | 3 | None |
| Comparative example 3 | 51 | 0.4 | 0-1.0 | 1.5 | Present |
| Comparative example 4 | 48 | 0 | 0 | 3 | None |

It can be seen in Table 5 that the average value of the nitrogen amounts was within the range of not less than 50 at% and not more than 65 at% for the examples. Furthermore, the average value of the oxygen amounts was within the range of not less than 1 at% and not more than 10 at%. Also, the minimum value and maximum value of the oxygen amounts in the five measurement regions both were within the range of not less than 1 at% and not more than 10 at%. From this result, it can be seen that oxygen was distributed inside the titanium nitride layer for the examples.

In contrast, the average value of the oxygen amounts was less than 1 at% for the comparative example 1. Also, the minimum value of the oxygen amounts in the five measurement regions was less than 0.1 at%. In other words, there were locations inside the titanium nitride layer at which the oxygen amount was less than 1 at% for the comparative example 1. The oxygen amount was not detected in the titanium nitride layer for the comparative example 2. This was because the vacuum furnace (the batch furnace) was used. Oxygen was not incorporated into the titanium nitride layer in the batch furnace because the processing was performed in a vacuum (not more than 10⁻³ Pa).

Also, a Ti-rich region was confirmed in the brazing material layer for the examples. In the Ti-rich region, the Ti content was within the range of not less than 30 at% and not more than 50 at%; the nitrogen content was within the range of not less than 1 at% and not more than 15 at%; the oxygen content was within the range of not less than 0 at% and not more than 3 at%; the Sn content was within the range of not less than 20 at% and not more than 40 at%; and the Cu content was within the range of not less than 0 at% and not more than 20 at%. These ratios were calculated using the sum of the Ti, Sn, Cu, N, and O content as 100 at%. Also, the area ratio of the Ti-rich region in the bonding layer was within the range of not less than 5% and not more than 30%. In contrast, the Ti-rich region was not observed for the comparative examples. The analysis method of the Ti-rich region was as described above.

Then, the ceramic circuit board was made by etching the bonded body. The shape of the circuit part, the shape of the jutting part of the bonding layer, etc., were respectively common between the examples and the comparative examples. A TCT test was performed on the ceramic circuit boards thus obtained.

Multiple conditions were used in the test. A first test A was performed for the ceramic circuit boards that used the silicon nitride substrates of the examples 1 to 4 and the comparative examples 1 to 2. A first test B was performed for the ceramic circuit boards that used the aluminum nitride substrates of the examples 5 to 6 and the comparative examples 3 to 4. In the first test A, one cycle included holding at -40 °C×30 minutes, holding at room temperature×10 minutes, holding at 200 °C×30 minutes, and holding at room temperature×10 minutes; and the presence of discrepancies of the ceramic circuit board after 3,000 cycles was measured. In the first test B, one cycle included holding at -20 °C×30 minutes, holding at room temperature×10 minutes, holding at 125 °C×30 minutes, and holding at room temperature×10 minutes; and the presence of discrepancies of the ceramic circuit board after 1,500 cycles was measured.

Also, a second test was performed for each ceramic circuit board of the examples and the comparative examples. In the second test, the sample was left for 20 hours in an environment of a temperature of 85 °C and a humidity of 85% before the TCT test, and then the TCT test was performed. The conditions of the TCT test were the same as those of the first test. In other words, the first test A was performed for the ceramic circuit boards of the examples 1 to 4 and the comparative examples 1 to 2. The first test B was performed for the ceramic circuit boards of the examples 5 to 6 and the comparative examples 3 to 4.

The presence of discrepancies of the ceramic circuit board was evaluated by measuring the crack occurrence area between the ceramic substrate and the metal plate. An ultrasonic flaw detection device (Scanning Acoustic Tomograh: SAT) was used to measure the crack occurrence area. The results are shown in Table 6. In Table 6, index eta (*η*) is the ratio of the crack occurrence area to the bonding area between the ceramic substrate and the metal plate. For example, eta (*η*) of 100% indicates that cracks did not occur; and eta (*η*) of 0% indicates that cracks occurred over the entire surface.

**[Table 6]**

| | η(%) after TCT test | |
|---|---|---|
| | First test | Second test |
| Example 1 | 100 | 100 |
| Example 2 | 100 | 100 |
| Example 3 | 100 | 100 |
| Example 4 | 100 | 100 |
| Example 5 | 100 | 100 |
| Example 6 | 100 | 100 |
| Comparative example 1 | 100 | 89 |
| Comparative example 2 | 100 | 84 |
| Comparative example 3 | 100 | 85 |
| Comparative example 4 | 100 | 80 |

It can be seen from Table 6 that in the first test, discrepancies were not confirmed for any of the examples or comparative examples. In the second test, discrepancies were not confirmed for the examples. In contrast, for the comparative examples, *η* was reduced compared to the first test result; and discrepancies were confirmed. It is considered that this was because oxidization of the titanium nitride layer proceeded while the ceramic circuit board was left in the environment of high temperature and high humidity. It can be seen from the test results that the ceramic circuit boards according to the examples were ceramic circuit boards resistant even to atmospheres of high temperature, high humidity, etc., in which oxidization occurs easily. Therefore, the ceramic circuit boards according to the examples are effective for semiconductor devices used in environments of high temperature or high humidity.

Embodiments of the invention include the following features.

### Feature 1

A bonded body, comprising:
a nitride ceramic member; and
a metal member bonded with the nitride ceramic member via a bonding layer,
a titanium nitride layer being formed at an interface between the nitride ceramic member and the bonding layer, the titanium nitride layer including titanium nitride as a major component,
the titanium nitride layer including a location at which an oxygen amount is not less than 1 at%.

### Feature 2

The bonded body according to Feature 1, wherein
a nitrogen amount at the location of the titanium nitride layer is not less than 20 at%.

### Feature 3

The bonded body according to Feature 1 or Feature 2, wherein
when area analysis of a 20 nm×20 nm measurement region of the titanium nitride layer is performed using TEM-EDX, and when a total of constituent elements other than carbon is taken as 100 at%:
an average value of oxygen amounts in any five measurement regions is not less than 1 at%; and
an average value of nitrogen amounts in the five measurement regions is not less than 20 at%.

### Feature 4

The bonded body according to Feature 3, wherein
the average value of the oxygen amounts is within a range of not less than 1 at% and not more than 10 at%, and
the average value of the nitrogen amounts is within a range of not less than 50 at% and not more than 65 at%.

### Feature 5

The bonded body according to Feature 4, wherein
in each of the five measurement regions, the nitrogen amounts are within a range of not less than 50 at% and not more than 65 at%, and the oxygen amounts are within a range of not less than 1 at% and not more than 10 at%.

### Feature 6

The bonded body according to any one of Features 1 to 5, wherein
the bonding layer includes:
Ti;
at least one selected from the group consisting of Cu and Ag; and
at least one selected from the group consisting of Sn, In, and C.

### Feature 7

The bonded body according to any one of Features 1 to 6, wherein
the bonding layer includes:
   the titanium nitride layer; and
   a brazing material layer positioned between the titanium nitride layer and the metal member,
the brazing material layer includes a Ti-rich region including not less than 30 at% of Ti, and
a nitrogen amount in the Ti-rich region is within a range of not less than 1 at% and not more than 15 at%.

### Feature 8

The bonded body according to Feature 7, wherein
when analysis of a 20 nm×20 nm measurement region of the brazing material layer is performed using TEM-EDX, the measurement region includes the Ti-rich region.

### Feature 9

The bonded body according to Feature 7 or Feature 8, wherein
when the bonding layer is observed at any cross section, an area ratio of the Ti-rich region in the bonding layer is within a range of not less than 5% and not more than 30%.

### Feature 10

The bonded body according to any one of Features 1 to 9, wherein
a thickness of the titanium nitride layer is within a range of not less than 0.1 µm and not more than 2 µm.

### Feature 11

The bonded body according to any one of Features 1 to 10, wherein
the metal members are bonded respectively to two surfaces of the nitride ceramic member via the bonding layers.

### Feature 12

A ceramic circuit board, comprising:
the bonded body according to any one of Features 1 to 11,
the nitride ceramic member having a substrate shape,
the metal member having a circuit configuration.

### Feature 13

A bonded body, comprising:
a nitride ceramic member; and
a metal member bonded with the nitride ceramic member via a bonding layer,
the bonding layer including a Ti-rich region,
in the Ti-rich region, when a sum of a Ti content, a Sn content, a Cu content, a nitrogen content, and an oxygen content is taken as 100 at%, the Ti content being not less than 30 at% and not more than 50 at%, the Sn content being not less than 20 at% and not more than 40 at%, the Cu content being not less than 0 at% and not more than 20 at%, the nitrogen content being not less than 1 at% and not more than 15 at%, and the oxygen content being not less than 0 at% and not more than 3 at%,
an area ratio of the Ti-rich region being within a range of not less than 5% and not more than 30%.

While certain embodiments of the inventions have been illustrated, these embodiments have been presented by way of example only, and are not intended to limit the scope of the inventions. These novel embodiments may be embodied in a variety of other forms; and various omissions, substitutions, modifications, etc., can be made without departing from the spirit of the inventions. These embodiments and their modifications are within the scope and spirit of the inventions, and are within the scope of the inventions described in the claims and their equivalents. Also, the embodiments above can be implemented in combination with each other.

### [Reference Numeral List]

1 bonded body
2 nitride ceramic substrate
3 copper member
4 bonding layer
5 titanium nitride layer
6 measurement region
7 brazing material layer
9 Ti-rich region
10 ceramic circuit board
11 circuit board
12 heat dissipation plate
14 semiconductor element
20 semiconductor device

## Claims

1. A bonded body (1), comprising:
a nitride ceramic member; and
a metal member bonded with the nitride ceramic member via a bonding layer (4),
a titanium nitride layer (5) being formed at an interface between the nitride ceramic member and the bonding layer (4), the titanium nitride layer (5) including titanium nitride as a major component,
the titanium nitride layer (5) including a location at which an oxygen amount is not less than 1 at%.

2. The bonded body (1) according to claim 1, wherein
a nitrogen amount at the location of the titanium nitride layer (5) is not less than 20 at%.

3. The bonded body (1) according to claim 1 or claim 2, wherein
when area analysis of a 20 nm×20 nm measurement region (6) of the titanium nitride layer (5) is performed using TEM-EDX, and when a total of constituent elements other than carbon is taken as 100 at%:
an average value of oxygen amounts in any five measurement regions (6) is not less than 1 at%; and
an average value of nitrogen amounts in the five measurement regions (6) is not less than 20 at%.

4. The bonded body (1) according to claim 3, wherein
the average value of the oxygen amounts is within a range of not less than 1 at% and not more than 10 at%, and
the average value of the nitrogen amounts is within a range of not less than 50 at% and not more than 65 at%.

5. The bonded body (1) according to claim 4, wherein
in each of the five measurement regions (6), the nitrogen amounts are within a range of not less than 50 at% and not more than 65 at%, and the oxygen amounts are within a range of not less than 1 at% and not more than 10 at%.

6. The bonded body (1) according to claim 1 or claim 2, wherein
the bonding layer (4) includes:
Ti;
at least one selected from the group consisting of Cu and Ag; and
at least one selected from the group consisting of Sn, In, and C.

7. The bonded body (1) according to claim 4, wherein
the bonding layer (4) includes:
Ti;
at least one selected from the group consisting of Cu and Ag; and
at least one selected from the group consisting of Sn, In, and C.

8. The bonded body (1) according to claim 5, wherein
the bonding layer (4) includes:
Ti;
at least one selected from the group consisting of Cu and Ag; and
at least one selected from the group consisting of Sn, In, and C.

9. The bonded body (1) according to claim 1 or claim 2, wherein
the bonding layer (4) includes:
the titanium nitride layer (5); and
a brazing material layer (7) positioned between the titanium nitride layer (5) and the metal member,
the brazing material layer (7) includes a Ti-rich region (9) including not less than 30 at% of Ti, and
a nitrogen amount in the Ti-rich region (9) is within a range of not less than 1 at% and not more than 15 at%.

10. The bonded body (1) according to claim 6, wherein
the bonding layer (4) includes:
the titanium nitride layer (5); and
a brazing material layer (7) positioned between the titanium nitride layer (5) and the metal member,
the brazing material layer (7) includes a Ti-rich region (9) including not less than 30 at% of Ti, and
a nitrogen amount in the Ti-rich region (9) is within a range of not less than 1 at% and not more than 15 at%.

11. The bonded body (1) according to claim 10, wherein when analysis of a 20 nm×20 nm measurement region (6) of the brazing material layer (7) is performed using TEM-EDX, the measurement region (6) includes the Ti-rich region (9).

12. The bonded body (1) according to claim 10, wherein when the bonding layer (4) is observed at any cross section, an area ratio of the Ti-rich region (9) in the bonding layer (4) is within a range of not less than 5% and not more than 30%.

13. The bonded body (1) according to claim 1 or claim 2, wherein a thickness of the titanium nitride layer (5) is within a range of not less than 0.1 µm and not more than 2 µm.

14. The bonded body (1) according to claim 5, wherein
a thickness of the titanium nitride layer (5) is within a range of not less than 0.1 µm and not more than 2 µm.

15. The bonded body (1) according to claim 12, wherein
a thickness of the titanium nitride layer (5) is within a range of not less than 0.1 µm and not more than 2 µm.

16. The bonded body (1) according to claim 5, wherein
the metal members are bonded respectively to two surfaces of the nitride ceramic member via the bonding layers (4).

17. The bonded body (1) according to claim 10, wherein
the metal members are bonded respectively to two surfaces of the nitride ceramic member via the bonding layers (4).

18. A ceramic circuit board (10), comprising:
the bonded body (1) according to claim 5,
the nitride ceramic member having a substrate shape,
the metal member having a circuit configuration.

19. A ceramic circuit board (10), comprising:
the bonded body (1) according to claim 10,
the nitride ceramic member having a substrate shape,
the metal member having a circuit configuration.

20. A bonded body (1), comprising:
a nitride ceramic member; and
a metal member bonded with the nitride ceramic member via a bonding layer (4),
the bonding layer (4) including a Ti-rich region (9),
in the Ti-rich region (9), when a sum of a Ti content, a Sn content, a Cu content, a nitrogen content, and an oxygen content is taken as 100 at%, the Ti content being not less than 30 at% and not more than 50 at%, the Sn content being not less than 20 at% and not more than 40 at%, the Cu content being not less than 0 at% and not more than 20 at%, the nitrogen content being not less than 1 at% and not more than 15 at%, and the oxygen content being not less than 0 at% and not more than 3 at%,
an area ratio of the Ti-rich region (9) being within a range of not less than 5% and not more than 30%.
